# EUROPEAN PATENT APPLICATION

(11) **EP 4 361 703 A1**
(43) Date of publication of application: **01.05.2024**
(21) Application number: 22204014.9
(22) Date of filing: 27.10.2022
(51) Int. Cl.: G02B 27/00, G02B 27/28

(54) **AN ILLUMINATION MODULE FOR A METROLOGY DEVICE**

(71) Applicant: ASML Netherlands B.V., 5500 AH Veldhoven (NL)
(72) Inventor: BUIJS, Robin, Daniel, 5500AH Veldhoven (NL); ZHOU, Zili, 5500 AH Veldhoven (NL); ARABUL, Mustafa, Ümit, 5500 AH Veldhoven (NL); BRULS, Dominique, Maria, 5500 AH Veldhoven (NL)
(74) Representative: ASML Netherlands B.V.

(57) **Abstract**

Disclosed is an illumination configuration module comprising: a polarizing and wavelength separation arrangement operable to separate input broadband illumination into at least first dispersed illumination comprising a first polarization state and second dispersed illumination comprising a second polarization state; a single spatial light modulation device operable to individually modulate each of the first dispersed illumination and second dispersed illumination to obtain first spectrally configured illumination and second spectrally configured illumination; and output optics operable to combine said first spectrally configured illumination and second spectrally configured illumination into an output illumination beam.

## Description

### FIELD

The present invention relates to an illumination configuration module for configuring a beam of illumination, and in particular such an illumination configuration module in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. In many cases, not all the spectral and/or polarization components of the white light are used for a particular measurement. For example, it is often desirable to vary the spectral and/or polarization characteristics of the radiation for a particular measurement. This can be achieved by filtering and polarization switching. This, however, comes with a system throughput penalty, as switching the radiation properties using present methods incurs a significant switching time penalty.

It is desirable to improve the configurability of measurement radiation characteristics.

### SUMMARY

According to a first aspect of the invention, there is provided illumination configuration module comprising: a polarizing element for separating radiation incident thereon into at first polarized component having a first polarization state and a second polarized component having a second polarization state; a dispersion element arranged to receive and spectrally disperse a beam of input broadband illumination or each of said first polarized component and second polarized component, said polarizing element and said dispersion element together being arranged to separate said beam of input broadband illumination into at least first dispersed illumination comprising said first polarization state and second dispersed illumination comprising said second polarization state; at least one spatial light modulation device operable to individually modulate each of the first dispersed illumination and second dispersed illumination to obtain first spectrally configured illumination and second spectrally configured illumination; and output optics operable to combine said first spectrally configured illumination and second spectrally configured illumination into an output illumination beam.

According to a second aspect of the invention, there is provided an illumination configuration module comprising: a polarizing and wavelength separation arrangement operable to separate input broadband illumination into at least first dispersed illumination comprising a first polarization state and second dispersed illumination comprising a second polarization state; at least one grating light valve device operable to individually modulate each of the first dispersed illumination and second dispersed illumination to obtain first spectrally configured illumination and second spectrally configured illumination; and an output optical arrangement operable to combine said first spectrally configured illumination and second spectrally configured illumination into an output illumination beam.

According to a third aspect of the invention, there is provided an illumination configuration module comprising: a filter arrangement comprising a plurality of dichromic filters to split an input broadband radiation beam into a plurality of beams each having different spectral characteristics; a polarizing beam splitting arrangement operable to split each of said beams having different spectral characteristics into respective differently polarized beams; at least one spatial light modulation device operable to individually modulate each of the differently polarized beams to obtain spectrally configured differently polarized beams; and output optics operable to combine said spectrally configured differently polarized beams into an output illumination beam

Other aspects of the invention comprise metrology device comprising an illumination arrangement according the first aspect, second aspect or third aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;
- Figure 6 depicts a schematic overview of an alignment sensor apparatus which may comprise a radiation source according to embodiments of the invention;
- Figures 7(a), 7(b) and 7(c) depict schematically a grating light valve (GLV), illustrating its basic operation in (a) a top view, (b) an end-on view in a first configuration and (c) an end-on view in a second configuration;
- Figures 8(a) and 8(b) depict schematically, respectively a top view and side view of a GLV based illumination configuration module;
- Figure 9 depicts schematically a top view of a GLV based illumination configuration module according to a first embodiment;
- Figure 10 depicts schematically a top view of a GLV based illumination configuration module according to a second embodiment;
- Figures 11(a) and 11(b) depict schematically a GLV arrangement configured for phase control between two polarization channels according to an embodiment;
- Figure 12 depicts schematically a GLV based illumination configuration module according to a third embodiment;
- Figure 13 depicts schematically a GLV based illumination configuration module according to a fourth embodiment;
- Figure 14(a) depicts schematically a GLV based illumination configuration module according to a fifth embodiment, and 14(b) a ray diagram showing the ray paths through the beam splitter arrangement of this embodiment; and
- Figure 15 depicts a block diagram of a computer system for controlling a broadband radiation source.

### DETAILED DESCRIPTION

In the present document, the terms "radiation" and "beam" are used to encompass all types of electromagnetic radiation, including one, some or all of: visible (e.g., 400nm-700nm) (near-) infrared radiation (700nm to 1000nm) ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

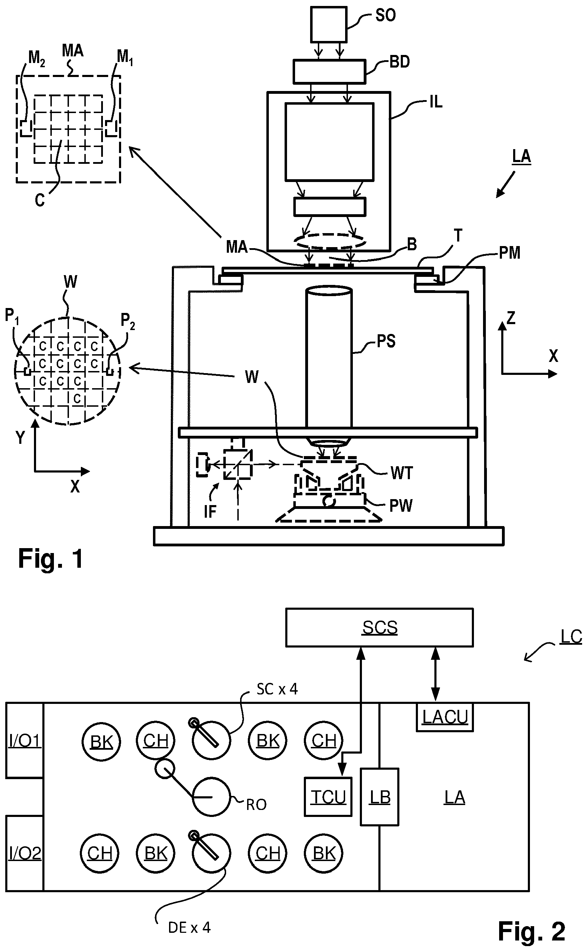

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

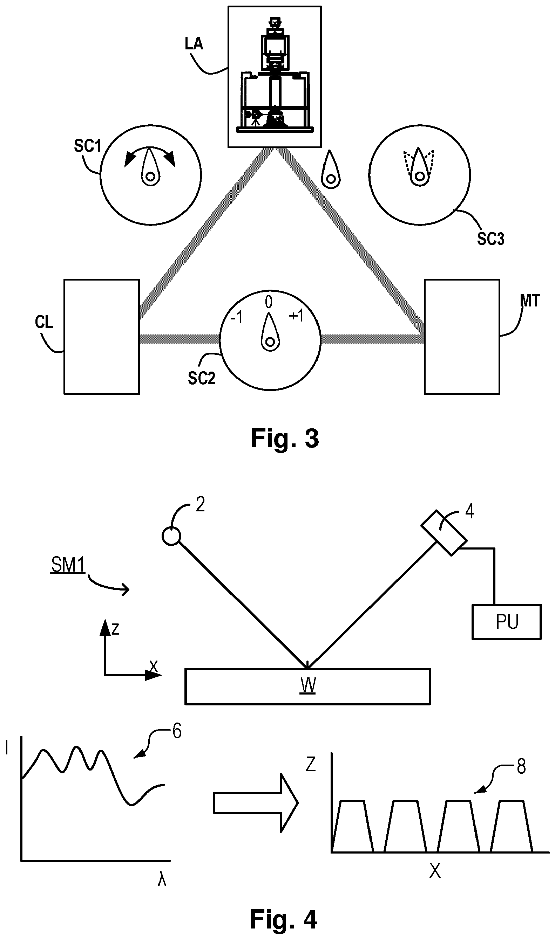

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

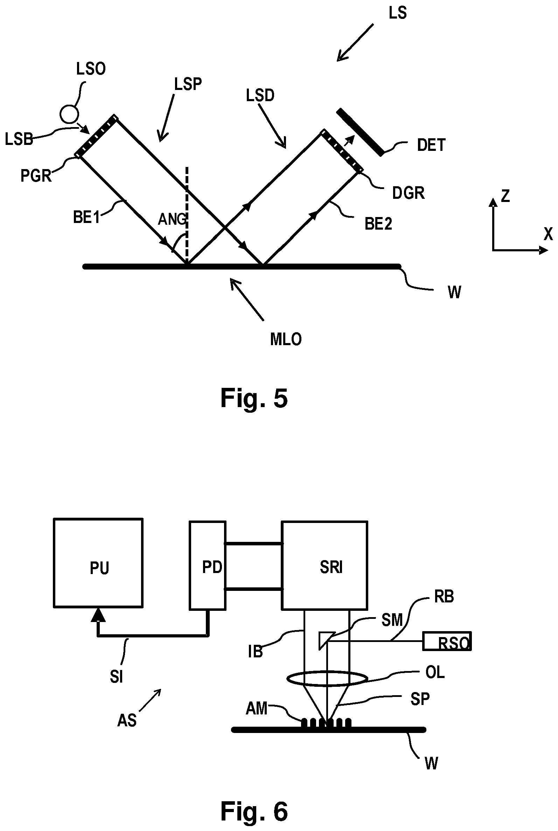

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies and/or polarization states to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

.In many metrology applications, such as scatterometry or interferometry based metrology applications, e.g., for performance of pre-exposure metrology (such as alignment) or post-exposure metrology (e.g., overlay, CD, focus or other parameter of interest metrology), different information can be obtained from measurement of the same structure depending on the wavelength and polarization state of the measurement illumination used. For example, some present metrology systems provide measurement illumination configurable over multiple colors and three polarization settings (Horizontal, Vertical and both). However, the presently used illumination configuration modules (color switching modules) in such systems tend to be based on bulky mechanical modules which are slow. Additionally, such modules provide only three options when selecting the polarization of the incident beam: all wavelengths at a first polarization state (e.g., horizontal H), all wavelengths at a second polarization state (e.g., vertical V) or all wavelengths at both of these polarizations. It is very possible that any one polarization choice is suboptimal at some wavelengths. To measure each wavelength at its optimum polarization would require twice as many measurements as a single polarization measurement, with a slow polarization switch halfway through. Furthermore, arbitrary combinations of different polarization states are simply not presently possible.

A fast illumination configuration module or color switching module has been described, based on the grating light valve (GLV) concept. A GLV module disperses light (having been dispersed onto the GLV) such that the module can selectively remove or modulate light at one or more specific wavelengths. The resulting spectrum can be configured to comprise any desired shape, and can be varied at very high frequencies, possibly up to the MHz range. Such engineered spectra are a fast (microsecond switchable) way to extract a large amount of information from a target. However the known literature on GLV based illumination configuration describes only color selection, without any polarization selection functionality. Wavelength is only one degree of freedom. Polarization of the measurement illumination is another useful degree of freedom which may be exploited in metrology.

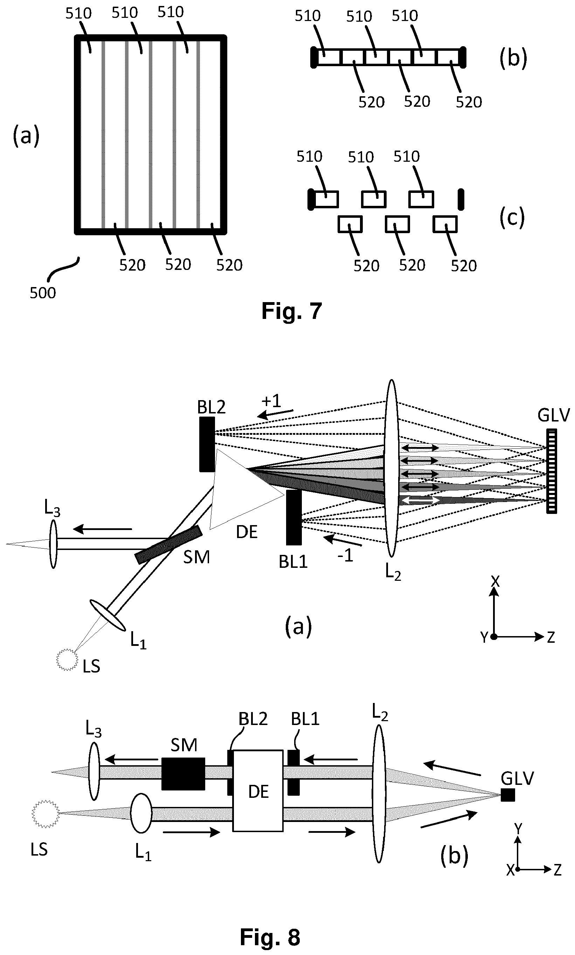

By way of example, and with reference to Figures 7 and 8, a GLV based illumination configuration module will now be described, configured to selectively transmit or block (diffract or reflect) at least part of incident broadband illumination. A GLV is an electrically-programmable diffraction grating based on Micro-Electro-Mechanical Systems (MEMS) technology. The GLV device may comprise configurable diffractive structures for selectively reflecting or diffracting the incident broadband illumination into an output radiation beam. Accordingly, output radiation illumination from such a module may comprise a spectrally configured beam having been modulated by the GLV device. A GLV device as used in embodiments disclosed herein may be a GLV device marketed by Silicon Light Machines (SLM), and/or based on GLV concept described in US6947613B, which is incorporated herein by reference.

Figures 7(a)-7(c) illustrate the working principal behind the GLV. Figures 7(a)-7(c) are schematic illustrations of a GLV pixel or component 500 from above and end-on, respectively. Please note that the GLV component shown in Figures 7(a)-7(c) is only an example design, other different GLV designs (e.g., the "true-GLV" design used in the G1088 and G8192 modules marketed by SLM) can also be used in any of the illumination configuration modules disclosed herein.

The GLV component comprises alternating GLV reflective ribbons of two types: static or bias ribbons 510 which are typically grounded along with a common electrode, and driven or active ribbons 520 which are driven by an electronic driver channel. A GLV device may comprise any number of these GLV components 500 arranged in an array (e.g., a 1D or 2D array). The active and bias ribbons may be essentially identical other than in how they are driven. In an embodiment, when no voltage is applied to the active ribbons 520, they are co-planar with the bias ribbons, a configuration illustrated in Figure 7(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 7(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

The GLV device may be used in a zeroth order mode such that the diffracted radiation is blocked/dumped and the specularly reflected (zeroth diffraction order) radiation is selected (e.g., transmitted into an output illumination beam). This has the advantage of preserving etendue. As such, an aperture stop may be provided in a pupil plane with the aim of maximizing transmission of the zeroth order, and maximizing blocking (minimizing transmission) of the first orders (and other diffraction orders). However, it can be appreciated that this may be reversed, such that the specular radiation is dumped and diffracted radiation is transmitted to the output.

Figures 8(a) and 8(b) schematically illustrate a known illumination configuration module from two different viewpoints. A broadband optical beam emitted from a broadband light source LS is dispersed in the X direction by a beam dispersion element DE, which may comprise, for example, a prism or a grating. The dispersion of the broadband optical beam is achieved based on the principle that the direction of the light emerging from the beam dispersion element DE is wavelength dependent. The broadband optical beam may be optionally collimated by a first optical lens L₁ before being dispersed by the beam dispersion element DE. The dispersed broadband optical beam may then be focused (e.g., by a second optical lens L₂) onto the ribbons of the GLV device which is located substantially at the focal plane of the second lens L₂. The different shading is indicative of different wavelengths of the dispersed radiation.

The GLV device may be configured in a zeroth order mode and is operable to apply a certain spatial modulation to the focused broadband optical beam so as to selectively reflect desired wavelengths and diffract away undesired wavelengths. In some embodiments, the GLV device may be operated in a wavelength selection mode to completely select one or more chosen wavelengths (e.g., without significant attenuation), and completely block the non-selected wavelengths. That is to say, the ribbons of the GLV device that correspond to the selected wavelengths may be set to equal heights such that they act like a standard mirror for the selected wavelengths and the other ribbons are actuated in such a way that they form a grating diffracting the undesired wavelengths into higher diffraction orders, e.g., -1^{st} and +1^{st} diffraction orders. These higher diffraction orders are then blocked or dumped by the beam blocks BL1, BL2, respectively. The GLV device may be operated also in intermediate modes or spectral shaping modes, e.g., to form a grating which partially reflects and partially diffracts the incident radiation for one or more wavelengths so as to attenuate but not completely block these one or more wavelengths. The degree of attenuation may be controlled via the ribbon configuration (the offset of the active ribbons with respect to the static ribbons). In this way, the spectral shape/constitution of the output radiation can be dynamically controlled.

The spatially modulated reflected (zeroth order) radiation from the GLV device may be captured by the second optical lens L₂. The spatially modulated optical beam is recombined on a return path, e.g., using the same dispersion element DE as was used to disperse the beam on the outward path (alternatively separate dispersion elements can be used for dispersing and combining). The return path within the dispersion element DE may be substantially parallel with and displaced in the Y direction with respect to the outward path. The recombined output illumination beam may then be directed by the steering mirror SM towards, for example, a third optical lens L₃. This third optical lens L₃ may act as an output lens so as to focus the optical beam into a metrology device; e.g., via a suitable optical fiber such as a single mode photonic crystal fiber.

It is proposed to improve on such an illumination configuration module to enable full wavelength and polarization configuration of the output illumination radiation, e.g., such that the output illumination is configurable to comprise any combination of available wavelengths and polarizations. For example, it is proposed that the output illumination may be configurable so as to comprise different wavelengths at different polarization states; e.g., it may comprise one or more wavelengths at a first polarization state, one or more wavelengths at a second polarization state and/or one more wavelengths at both polarization states. In other embodiments, more than two polarization states may be selectable. The proposed illumination configuration module may enable both wavelengths and/or polarizations to be switched with microsecond magnitude switching time.

The embodiments below are described in relation to using a spatial modulation device based on GLV technology for spectral shaping and/or wavelength selection. However, it will be appreciated that the spatial modulation device may comprise another type of spatial light modulation device and/or MEMS device, at least in some embodiments.

A proposed embodiment may separate input broadband illumination into at least first dispersed illumination comprising a first polarization state and second dispersed illumination comprising a second polarization state (more dispersed illumination comprising additional polarization states may additionally be provided). This may be achieved using a polarizing and wavelength separation arrangement (e.g., a polarizing element and a dispersion element). A spatial light modulation device such as a GLV device can then be used to individually modulate each of the first dispersed illumination and second dispersed illumination to obtain first spectrally configured illumination and second spectrally configured illumination. The first spectrally configured illumination and second spectrally configured illumination can then be used as measurement illumination in measurement; e.g., by combining into an output illumination beam or measurement illumination beam using an output optical arrangement.

In this manner, it is possible to engineer the spectra comprised in the output illumination beam in terms of both intensity versus wavelength and polarization versus wavelength.

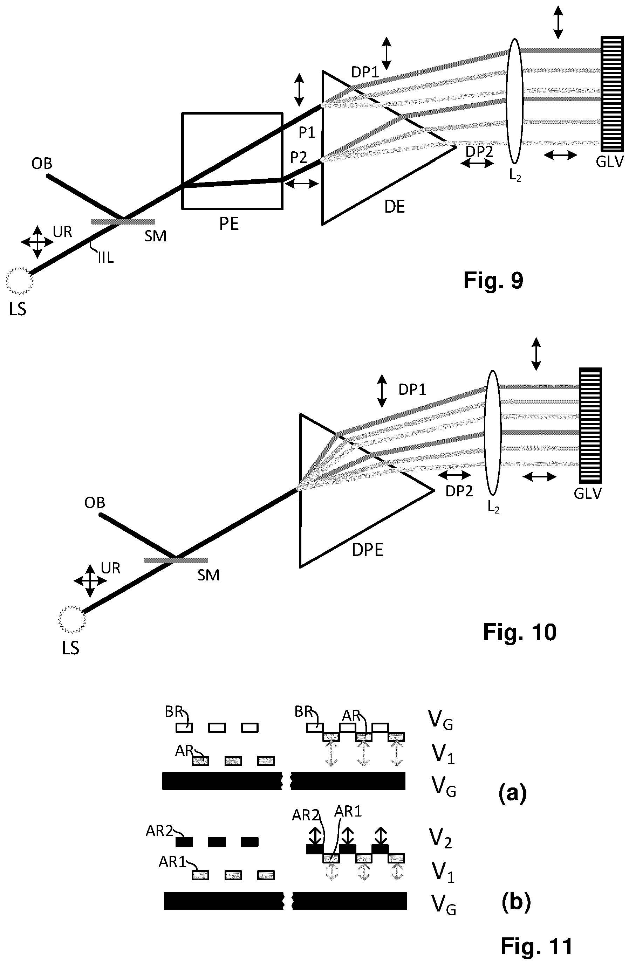

Figure 9 schematically illustrates a first embodiment of an illumination configuration module according to concepts disclosed herein. A broadband illumination source LS provides (e.g., unpolarized) broadband input illumination IIL. A polarizing element PE or polarizing beam spitter separates the input illumination into first polarized illumination P1 comprising a first polarization state and second polarized illumination P2 comprising a second polarization state. For example, the first polarization state and second polarization state may comprise mutually orthogonal linear polarization states (e.g., H and V polarization states). For example, polarizing element PE or polarizing beam spitter may comprise a birefringent element (e.g. birefringent crystal), having an index of refraction that depends strongly on polarization. Such a birefringent crystal can split the incident beam into two such output beams, respectively comprising a horizontal polarization and a vertical polarization.

The first polarized illumination P1 and second polarized illumination P2 may be dispersed by a dispersion element DE. Note that the order of the polarizing element PE and dispersion element DE may be reversed such that the input beam is dispersed before being polarized into two (or more) different polarizations. As such, a polarizing and wavelength separation arrangement within the context of this disclosure may comprise at least one dispersion element DE and at least one polarizing element PE in any order.

Since the illumination is now spatially separated into first dispersed illumination DP1 and second first dispersed illumination DP2, each comprising a different polarization state, each of these dispersed illuminations DPI, DP2 can be projected onto different regions of the GLV device (or each on a different respective GLV device) and spectrally shaped separately. The illumination specularly reflected (or alternatively diffracted) off the GLV device can be recombined by output optics into a single output beam OB, which can be steered as required using a steering mirror SM (e.g., towards a metrology device) . As shown here, the output optics may comprise the same polarizing and wavelength separation arrangement (e.g., the dispersion element DE and polarizing element PE) as used to disperse and polarize/split the incoming radiation.

The illumination configuration module system is shown as comprising one lens and one GLV; however, it may be implemented using two (or more) separate lenses and/or GLVs. The diffraction orders from the GLV are not drawn, but may be blocked in the same way as illustrated in Figure 8(a). A slightly longer focal length of the lens may be used to ensure adequate separation of the diffraction orders, given the larger extent of the two spots.

In the example described, the incoming beam is unpolarized. Depending on the light source, this beam may instead be circularly polarized or linearly polarized; in the latter case an input wave plate may be provided to convert the linearly polarized radiation so as to comprise (e.g., an equal amount of) H and V radiation (e.g., such that it is circularly polarized). As such, the radiation incident on the polarizing element may be unpolarized, circularly polarized or 45 degree linearly polarized.

In the embodiment described, a polarizing element PE and dispersion element DE are used in combination to convert a broadband unpolarized (or linearly, or circular polarized etc.) beam into two separate dispersed spectra with orthogonal polarization states. One method of achieving this is to mount a slab of birefringent material directly onto one face of a dispersing prism. Other shapes and arrangements or birefringent crystals (such as Wollaston prisms) can achieve the same result.

If a material comprises an appropriate balance between dispersion and birefringence, it may be possible to use such a material to form a prism which can perform both polarization and dispersion functions at once, creating two separate dispersed spectra with orthogonal polarization states.

Figure 10 illustrates an illumination configuration module according to such an embodiment where the polarizing and wavelength separation arrangement is a single element. As such, the only difference is that the polarizing element PE and dispersion element DE have been replaced by a single dispersing and polarizing element DPE, such as a dual-polarization dispersive prism. One advantage of using such a dual-polarization dispersive prism is that it comprises fewer optical surfaces compared to separate elements DE, PE, and therefore lower losses from reflections and aberrations.

The above described embodiments allow for control of the illumination intensity in two (or more) polarization channels as a function of wavelength. In a further embodiment, it is proposed to provide an additional control of the phase between these channels at each wavelength, therefore enabling other polarization states to be comprised within the combined output illumination beam. In this manner, spectra with fully arbitrary states of polarization can be engineered. This method requires a beam that has a well-defined polarization. Therefore, if the source is unpolarized, an additional polarizer may be provided at a position after the source.

This can be achieved, for example, by adding a spatial light modulator (SLM) in the path to the illuminator. For example, a transmissive SLM may be located between the lens focusing the dispersed radiation onto the GLV module (e.g., between lens L2 and the GLV module in Figures 8 to 10). Each SLM pixel would correspond to a GLV position and could be set to a desired phase delay. This is only an example and any other optically equivalent arrangement may be implemented, including using a reflective SLM. In fact, an SLM could fully replace the GLV, using the same position and orientation. A phase ramp in a given SLM position could be used to selectively deflect that part of the spectrum to a beam dump. A flat phase would set the phase for the color and polarization combination in that location.

Alternatively, a more compact implementation of such phase control may be achieved by configuring the GLV device such that it provides both intensity and phase controls on each pixel. By way of explanation, a beam comprising equal amounts of H and V light can be diagonally polarized, circularly polarized, or elliptically polarized, depending on the relative phase between the H and V components. A GLV that provides phase control in addition to regular GLV operation, enables control of the relative phase and therefore creation of specific polarization states.

The concept will be explained with reference to Figure 11. In a conventional GLV, as illustrated in Figure 11(a) the individual ribbons are divided into two groups, active ribbons AR, to which a first voltage level V₁ is selectively applied, and (static) bias ribbons BR which are maintained at the ground voltage V_{G}. As such, only the active ribbons AR move. In this proposed embodiment, as illustrated in Figure 11(b), an additional voltage level V₂ is provided such that the first voltage level V₁ sets a first active set of ribbons AR1 and a second voltage level sets a second active set of ribbons AR2. In this manner, each of the sets of ribbons AR1, AR2 can have their position (height) varied, thereby enabling the path length and therefore phase between portions of the radiation to be varied (e.g., between the first dispersed illumination and second dispersed illumination). Using such a device, fully polarization controlled spectral weighting may be performed with no other change in components. This design provides control of the phase between the two polarization channels for each individual color. Because the two phase-controlled polarization channels are recombined coherently in the output branch, each color will take on a desired arbitrary polarization state depending on the phase between the channels, as well as a desired intensity.

The spectro-polarimetrically shaped light may be used in a metrology device, e.g., such that spatial modulation device (illumination device) produces a radiation spectrum, discretized into a plurality of wavelength bins. Each bin may be provided with programmable intensity and programmable polarization state.

Such a metrology apparatus may be able to optimize the illumination characteristics, e.g., for maximum sensitivity to parameters of interest. It is also known that spectral shaping, where each wavelength bin has its own programmed intensity, provides an further advantage in overlay measurement. An apparatus that can set a polarization state for each wavelength bin can further optimize the illumination characteristics, as the optimal polarization state will depend on wavelength.

Depending on the implementation, the polarization state may either be selected between two polarization states (such as horizontal and vertical) or from a continuous range of polarization states (including circular polarization and the elliptical states in between).

A number of embodiments will now be described which do not use a dispersion element or prism and a birefringent crystal, but use instead a filter arrangement comprising a plurality of dichroic filters to split the input illumination into a plurality of beams each having different spectral characteristics and polarizing beam splitters to split each wavelength into two (or more) respective differently polarized beams, which can then be modulated into two or more spectrally configured differently polarized beams.

The dichroic filter and polarizing (mini or micro) beam splitters may be combined into a compound optical element. Such a compound optical element may be attached directly onto the GLV device e.g. at the position and/or instead of the cover window of the GLV device. This type of integrated optical element can be found e.g., in digital LCD projectors, where they are typically used for polarization recycling, but usually without a color separation function.

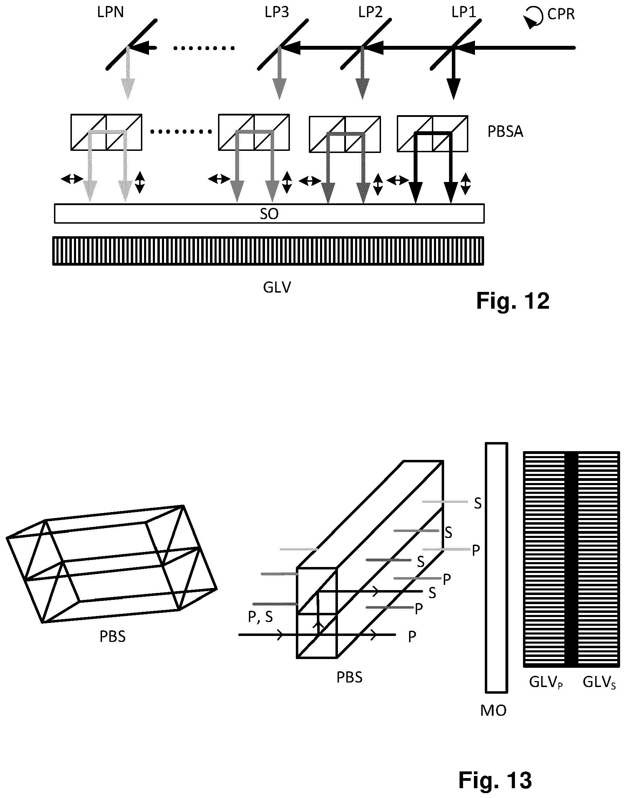

Figure 12 is a schematic illustration of such a concept. Broadband circularly polarized radiation CPR is incident onto a first dichromic long pass filter LP1. A first component of the spectrum, e.g., the blue component, is split off and transmitted to a first pair of beam splitters in a polarizing beam splitter array PBSA. The remainder of the illumination is transmitted and split at a second long pass filter LP2 where a second portion is diverted to a second pair of beam splitters of the polarizing beam splitter array PBSA. This may be repeated for a third long pass filter LP3 and up to any number N of further filters. The polarized beams may be shaped by (optional) shaping optics SO before being modulated by the GLV device.

The filters can be e.g. dichroic LP filters with a steep filter edge. Alternatively, short pass filters may be used, in which case the beam separation occurs in the opposite spectral direction (e.g., starting from the (near) infrared wavelengths). As another alternative, filters which reflect out a small peak from the inbound beam (e.g., notch filters) can be used. In that way, each "picked" beam can have a very narrow width.

Irrespective of which filter configuration is chosen, the broadband spectrum will be split into spatially separated wavelength components/peaks. The effect of the PBS array on such beams depends on the initial polarization state of the incoming light. In an embodiment, the incoming radiation may be circular polarized (e.g., by action of a quarter wave plate on a linearly polarized broadband source). It is also possible to use linearly polarized light at 45 degrees, however, the exact polarization angle orientation of the inbound beam with respect to the PBS array would determine the exact splitting ratio between the two polarization states at the exit of the PBS array. Using circular polarized light will ensure a 50%-50% split between the two exit branches. Therefore, circularly polarized illumination may be preferred. In an embodiment, a quarter wave plate may be placed after each long pass filter, in each case optimized for its respective color.

The PBS array which will transmit a first polarization and will reflect a second polarization of incident circularly polarized light. By placing two identical PBS cubes adjacent each other, the two polarizations will be spatially separated. As such, for every color, two adjacent beams will be incident on the GLV, comprising mutually perpendicular polarization states.

Alternatively, instead of a PBS array, an array comprising Wollaston prisms may be used. However, due to the nature of polarization splitting in such devices, the two output beams may be non-parallel such that at least one of these beams may need to be steered or redirected towards the GLV device.

Where the GLV device comprises a dual-ribbon GLV (or two individual GLVs), the number of addressable bands is not limited by the PBS size, but solely dependent on the color separation optics. Such an arrangement is illustrated in Figure 13, where the GLV comprises a first active area GLV_{P} for the colors of a first polarization state (e.g., P polarized radiation) and a second active area GLVs for the colors of a second polarization state (e.g., S polarized radiation). In this example, the radiation has already been separated into different colors, e.g. by the color filter stack as described in the implementation of Figure 12. These filtered wavelength components may be projected adjacent to each other onto a stack of two elongated PBSs (or two polarization-dependent dichroic mirrors). In this case micro optics MO may be used to focus the light, although alternatively a large single lens (e.g., lens L₂ of Figures 8 to 10) can be used off-axis to separate the ingoing and outgoing beams.

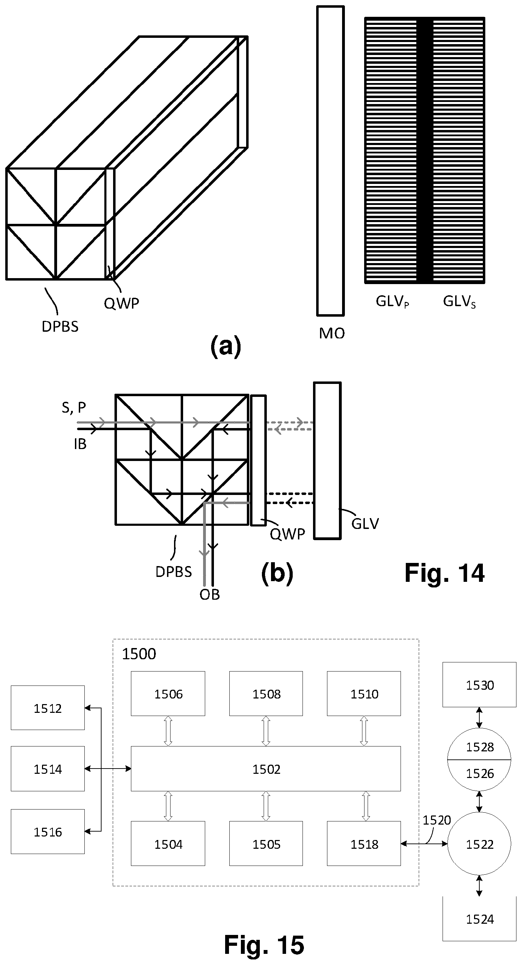

Figure 14(a) illustrates another embodiment, which comprises a dual PBS unit DPBS, configured as shown, and quarter wave plate QWP, in front of the GLV device. The micro optics MO and dual-ribbon GLV are as shown in the previous figure. The dual PBS unit may comprise two pairs of PBSs with the internal splitting surfaces being oppositely oriented in the direction between an input face and the quarter wave plate QWP.

In this arrangement, the light propagating towards the GLV has its polarization state switched due to passing twice through the quarter wave plate QWP. The two reflected light beams, with orthogonal polarization states will then be diverted downwards (as illustrated), forming the output beam. In this output beam, the two polarization states are combined within one beam, which facilitates the recombination of all color bands into one single beam, to be e.g., coupled into an optical fiber, of free-space into a sensor module. The incoming light can also be circularly polarized, as the first PBS element will take care of the splitting of the light into two orthogonal polarized beams.

Figure 14(b) shows the light path (for one color) through the dual PBS unit DPBS and quarter wave plate QWP shown in more detail for a single color. In this example, an input beam IB is shown entering from the left hand top side, represented as comprising an S-polarized component (gray) and P-polarized component (black). This input radiation may be unpolarized, have circular polarization, or otherwise comprise both S and P polarizations (e.g., a 50:50s split thereof). Considering first the S-polarized component (gray), the two PBSs at the upper part of the figure will transmit this S-polarized radiation and reflect P-polarized radiation. The quarter waveplate QWP will convert the -polarized radiation into circularly polarized radiation (gray dotted) which is transmitted to the GLV module. The resultant reflected radiation from the GLV module will again be transmitted through the quarter waveplate QWP to become P polarized (black). Therefore the returning beam will be diverted downwards by the top right PBS. The bottom PBSs transmit P polarized light and reflect S polarized light, hence the light will be transmitted further from top downwards into the output beam OB.

The P-polarized component will follow a different route. The incoming P polarized component (black) will hit the top-left PBS, and will be reflected. The left bottom PBS reflects P polarized light (this PBS could be replaced by a mirror). As already mentioned, the bottom-right PBS transmits P-polarized light. The light passes through the quarter waveplate QWP on its way to the GLV and becomes circularly polarized (black dotted). After reflection at the GLV and passing again through the quarter waveplate QWP to become S-polarized, the light will be reflected by the bottom right PBS, and also be diverted downwards into the output beam OB.

The advantage of this geometry is that the incoming and outgoing beam are perpendicular, thus enabling easy separation between the inbound and outbound optical path.

For proper operation, the illumination may be properly focused onto the GLV. This can be done by shaping optics in front of the GLV, such as a micro lens array, or an integrated optical element combined with the GLV window or combined with the PBS array.

The reflected beams from the GLV need to be collected. This can be achieved in several ways, depending on the specific implementation. For example, the radiation may be configured to be incident on the GLV at an angle, such that the incoming and returning beams paths can be separated. In the return path, a second PBS array (e.g., similar to that shown in the input path) may be used to overlap pairs of beams with the same color, but different polarization states into a combined beam that can be modulated both in polarization and amplitude. These combined beams can be further combined again using a second array of dichroic color filters, or dispersion element/prism. The illumination collection and higher order separation can be implemented by e.g., relay optics such as fly-eye lens arrays or micro lens arrays.

Also, by adding quarter wave plates it is possible to change the polarization, which will separate the incoming and outbound beam by 90 degrees once this beam goes subsequently goes through a PBS. As the incoming and outbound beams are at exactly 90 degrees, all other angles can be filtered out, as this is the angular space at which the unwanted higher reflected orders are present. Also, the incoming filter array could be extended in one dimension, such that the same array is used for incoupling and outcoupling. Several implementations are possible depending on space requirements and final spot requirements.

Multiple metrology devices, such as those described and illustrated herein (e.g., scatterometers, level sensors, alignment sensors, holographic microscopes etc..) could benefit from polarization resolved spectral weighting using the methods and arrangements described herein.

Figure 15 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1508 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1528. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1530 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Additional embodiments are being disclosed in the subsequent list of numbered clauses:
1. An illumination configuration module comprising:
   a polarizing element for separating radiation incident thereon into at first polarized component having a first polarization state and a second polarized component having a second polarization state;
   a dispersion element arranged to receive and spectrally disperse a beam of input broadband illumination or each of said first polarized component and second polarized component, said polarizing element and said dispersion element together being arranged to separate said beam of input broadband illumination into at least first dispersed illumination comprising said first polarization state and second dispersed illumination comprising said second polarization state;
   at least one spatial light modulation device operable to individually modulate each of the first dispersed illumination and second dispersed illumination to obtain first spectrally configured illumination and
   second spectrally configured illumination; and
   output optics operable to combine said first spectrally configured illumination and second spectrally configured illumination into an output illumination beam.
2. An illumination configuration module as defined in clause 1, wherein the polarizing element comprises a polarizing beam splitter.
3. An illumination configuration module as defined in clause 2, wherein the polarizing element comprises a birefringent element.
4. An illumination configuration module as defined in any preceding clause, wherein the dispersion element comprises a prism or a grating.
5. An illumination configuration module as defined in any preceding clause, wherein the polarizing element and dispersing element are individual elements.
6. An illumination configuration module as defined in clause 5 wherein said dispersing element is between said polarizing element and said at least one spatial light modulation device, such that said polarizing element separates said beam of input broadband illumination into said first polarized component and said second polarized component, and said dispersing element disperses each of said first polarized component and said second polarized component to obtain said first dispersed illumination and second dispersed illumination.
7. An illumination configuration module as defined in clause 5 wherein said polarizing element is between said dispersing element and said at least one spatial light modulation device, such that said dispersing element disperses said beam of input broadband illumination and said polarizing element separates the dispersed beam of input broadband illumination into said first dispersed illumination and second dispersed illumination.
8. An illumination configuration module as defined any preceding clause, wherein the polarizing element is directly mounted onto a face of the dispersion element.
9. An illumination configuration module as defined in clause 1, wherein the polarizing element and dispersing element are implemented as a single dispersing and polarizing element.
10. An illumination configuration module as defined in clause 9, wherein said single dispersing and polarizing element comprises a dual-polarization dispersive prism.
11. An illumination configuration module as defined in any preceding clause comprising only a single dispersion element.
12. An illumination configuration module as defined in any preceding clause comprising only a single polarizing element.
13. An illumination configuration module as defined in any preceding clause, comprising an input wave plate operable to transform linearly polarized input broadband illumination into circularly polarized broadband illumination.
14. An illumination configuration module as defined in any preceding clause, wherein said first polarization state and second polarization state comprise mutually orthogonal polarization states.
15. An illumination configuration module as defined in any preceding clause, wherein said at least one spatial light modulation device comprises at least one grating light valve device.
16. An illumination configuration module as defined in clause 15, wherein said at least one grating light valve device comprises an active area operable to modulate said first dispersed illumination and said second dispersed illumination on different respective regions of said active area.
17. An illumination configuration module as defined in clause 15, wherein said at least one grating light valve device comprises a dual-ribbon grating light valve device comprising a first active area operable to modulate said first dispersed illumination and a second active area operable to modulate said second dispersed illumination.
18. An illumination configuration module as defined in clause 15, wherein said at least one grating light valve device comprises a first grating light valve device operable to modulate said first dispersed illumination and a second grating light valve device operable to modulate said second dispersed illumination.
19. An illumination configuration module as defined in any of clauses 15 to 18, wherein each said at least one grating light valve device comprises a first set of active ribbons and a second set of active ribbons so as to be operable to control phase between said first dispersed illumination and said second dispersed illumination, and therefore impose an arbitrary polarization state on the output illumination beam.
20. An illumination configuration module as defined in any of clauses 1 to 18, comprising an additional spatial light modulation device being operable to selectively impose a phase delay to said first dispersed illumination and/or said second dispersed illumination.
21. An illumination configuration module as defined in any of clauses 1 to 18, wherein said at least one spatial light modulation device is further operable to selectively impose a phase delay to said first dispersed illumination and/or said second dispersed illumination.
22. An illumination configuration module as defined in any preceding clause, wherein said output optics comprises said polarizing element and said dispersion element.
23. An illumination configuration module as defined in any preceding clause, wherein said at least one spatial light modulation device is operable to control intensity of each spectral component of said first spectrally configured illumination and second spectrally configured illumination.
24. An illumination configuration module comprising:
   a polarizing and wavelength separation arrangement operable to separate input broadband illumination into at least first dispersed illumination comprising a first polarization state and second dispersed illumination comprising a second polarization state;
   at least one grating light valve device operable to individually modulate each of the first dispersed illumination and second dispersed illumination to obtain first spectrally configured illumination and
   second spectrally configured illumination; and
   an output optical arrangement operable to combine said first spectrally configured illumination and
   second spectrally configured illumination into an output illumination beam.
25. An illumination configuration module comprising:
   a filter arrangement comprising a plurality of dichromic filters to split an input broadband radiation beam into a plurality of beams each having different spectral characteristics;
   a polarizing beam splitting arrangement operable to split each of said beams having different spectral characteristics into respective differently polarized beams;
   at least one spatial light modulation device operable to individually modulate each of the differently polarized beams to obtain spectrally configured differently polarized beams; and
   output optics operable to combine said spectrally configured differently polarized beams into an output illumination beam.
26. An illumination configuration module as defined in clause 25, wherein said plurality of dichromic filters comprise all long-pass filters or comprise all short-pass filters, said filters being arranged in order of the filter wavelength.
27. An illumination configuration module as defined in clause 25, wherein said plurality of dichromic filters comprise a plurality of notch filters.
28. An illumination configuration module as defined in any of clauses 25 to 27, wherein each said polarizing beam splitting arrangement comprises a respective pair of polarizing beam splitters for each of said beams having different spectral characteristics.
29. An illumination configuration module as defined in any of clauses 25 to 27, wherein said polarizing beam splitting arrangement comprises a pairs of elongated polarizing beam splitters.
30. An illumination configuration module as defined in any of clauses 25 to 27, wherein said polarizing beam splitting arrangement comprises two pairs of elongated polarizing beam splitters and a quarter wave plate.
31. A metrology device comprising an illumination configuration module as defined in any preceding clause, operable to use said output illumination beam as measurement illumination for a measurement.
32. A metrology device as defined in clause 31, wherein the metrology device comprises a scatterometer, interferometer or holographic microscope.
33. A metrology device as defined in clause 31 or 32, wherein the metrology device comprises an alignment sensor or level sensor.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination configuration module comprising:
a polarizing element for separating radiation incident thereon into at first polarized component having a first polarization state and a second polarized component having a second polarization state;
a dispersion element arranged to receive and spectrally disperse a beam of input broadband illumination or each of said first polarized component and second polarized component, said polarizing element and said dispersion element together being arranged to separate said beam of input broadband illumination into at least first dispersed illumination comprising said first polarization state and second dispersed illumination comprising said second polarization state;
at least one spatial light modulation device operable to individually modulate each of the first dispersed illumination and second dispersed illumination to obtain first spectrally configured illumination and
second spectrally configured illumination; and
output optics operable to combine said first spectrally configured illumination and second spectrally configured illumination into an output illumination beam.

2. An illumination configuration module as claimed in claim 1, wherein the polarizing element comprises at least one of: a polarizing beam splitter, the polarizing element comprises a birefringent element.

3. An illumination configuration module as claimed in any preceding claim, wherein the dispersion element comprises a prism or a grating.

4. An illumination configuration module as claimed in any preceding claim, wherein the polarizing element and dispersing element are individual elements.

5. An illumination configuration module as claimed in claim 4 wherein said dispersing element is between said polarizing element and said at least one spatial light modulation device, such that said polarizing element separates said beam of input broadband illumination into said first polarized component and said second polarized component, and said dispersing element disperses each of said first polarized component and said second polarized component to obtain said first dispersed illumination and second dispersed illumination.

6. An illumination configuration module as claimed in claim 4 wherein said polarizing element is between said dispersing element and said at least one spatial light modulation device, such that said dispersing element disperses said beam of input broadband illumination and said polarizing element separates the dispersed beam of input broadband illumination into said first dispersed illumination and second dispersed illumination.

7. An illumination configuration module as claimed any preceding claim, wherein the polarizing element is directly mounted onto a face of the dispersion element.

8. An illumination configuration module as claimed in claim 1, wherein the polarizing element and dispersing element are implemented as a single dispersing and polarizing element, and, optionally, wherein said single dispersing and polarizing element comprises a dual-polarization dispersive prism.

9. An illumination configuration module as claimed in any preceding claim comprising only a single dispersion element.

10. An illumination configuration module as claimed in any preceding claim comprising only a single polarizing element.

11. An illumination configuration module as claimed in any preceding claim, comprising an input wave plate operable to transform linearly polarized input broadband illumination into circularly polarized broadband illumination.

12. An illumination configuration module as claimed in any preceding claim, wherein said first polarization state and second polarization state comprise mutually orthogonal polarization states.

13. An illumination configuration module as claimed in any preceding claim, wherein said at least one spatial light modulation device comprises at least one grating light valve device.

14. An illumination configuration module as claimed in claim 13, wherein said at least one grating light valve device comprises at one of the following options:
- an active area operable to modulate said first dispersed illumination and said second dispersed illumination on different respective regions of said active area,
- a dual-ribbon grating light valve device comprising a first active area operable to modulate said first dispersed illumination and a second active area operable to modulate said second dispersed illumination, and
- a first grating light valve device operable to modulate said first dispersed illumination and a second grating light valve device operable to modulate said second dispersed illumination.

15. A metrology device comprising an illumination configuration module as claimed in any preceding claim, operable to use said output illumination beam as measurement illumination for a measurement.
